Europäisches Patentamt

European Patent Office

Office européen des brevets

(19)

(11) Numéro de publication: **0 326 466**
**A1**

## (12) DEMANDE DE BREVET EUROPEEN

(21) Numéro de dépôt: **89400171.8**

(22) Date de dépôt: **20.01.89**

(51) Int. Cl.⁴: $H\ 03\ L\ 7/02$

(30) Priorité: **22.01.88 FR 8800680**

(43) Date de publication de la demande:
**02.08.89 Bulletin 89/31**

(84) Etats contractants désignés: **CH DE GB IT LI**

(71) Demandeur: **THOMSON-CSF**
**51, Esplanade du Général de Gaulle**
**F-92800 Puteaux (FR)**

(72) Inventeur: **Auneau, Gisèle**
**THOMSON-CSF SCPI 19, avenue de Messine**
**F-75008 Paris (FR)**

**Boulanger, Alain**
**THOMSON-CSF SCPI 19, avenue de Messine**
**F-75008 Paris (FR)**

(74) Mandataire: **Chaverneff, Vladimir et al**
**THOMSON-CSF SCPI**
**F-92045 PARIS LA DEFENSE CEDEX 67 (FR)**

(54) **Dispositif d'asservissement en fréquence d'un oscillateur.**

(57) L'invention concerne les dispositifs d'asservissement en fréquence, notamment ceux du type à prépositionnement

L'invention réside dans le fait que l'on s'affranchit des dérives du discriminateur de fréquence (2) en effectuant des calibrations de ce dernier à l'aide de deux signaux de fréquences connues Fo et F1 fournis par un générateur (4). Le signal résultant de cette calibration permet d'élaborer une tension de référence pour un convertisseur numérique analogique (18) qui fournit alors une tension représentative de la tension de commande de l'oscillateur (1).

Le dispositif de l'invention peut être mis en oeuvre dans une boucle d'asservissement en phase.

FIG. 1

EP 0 326 466 A1

# Description

## DISPOSITIF D'ASSERVISSEMENT EN FREQUENCE D'UN OSCILLATEUR

L'invention concerne les dispositifs d'asservissement en fréquence d'un oscillateur et, plus particulièrement un dispositif de ce type dans lequel il est prévu un prépositionnement de la fréquence avant l'opération d'asservissement proprement dite.

Les générateurs de signaux à différentes fréquences utilisent souvent des oscillateurs à fréquence variable qui sont commandés par une tension, plus connus sous l'abréviation anglo-saxonne V. C. O. pour "Voltage Controlled Oscillator". Les différentes fréquences sont obtenues en appliquant des tensions de valeurs déterminées à cet oscillateur, chaque valeur correspondant à une fréquence et, en comparant la fréquence du signal de sortie de l'oscillateur, éventuellement multipliée ou divisée, à une fréquence étalon fournie par un oscillateur stable en fréquence tel qu'un oscillateur à quartz. Cette comparaison est effectuée à l'aide d'un détecteur de phase qui permet d'élaborer un signal d'erreur servant à modifier la fréquence de l'oscillateur à fréquence variable de manière à réduire ce signal d'erreur.

Dans un tel dispositif d'asservissement en fréquence, on comprend que des dérives importantes de fréquence apparaissent en fonction de la variation des caractéristiques des composants, notamment en fonction de la température et de leur taux de vieillissement. Pour remédier à cet inconvénient, on est conduit à utiliser des composants calibrés et triés avec précision, peu sensibles à la température et même à mettre en oeuvre des enceintes thermostatiques pour protéger certains composants contre les variations de la température. Une telle manière de faire conduit à des dispositifs qui sont compliqués et coûteux.

Le but de la présente invention est donc de réaliser un dispositif d'asservissement en fréquence qui est stable en température et au cours du temps sans avoir recours à des composants particuliers ou à des enceintes thermostatiques.

Pour atteindre ce but, l'invention réalise dans le dispositif d'asservissement en fréquence, une autocalibration d'un élément important qui est le discriminateur de fréquence.

L'invention se rapporte à un dispositif d'asservissement en fréquence d'un oscillateur du type à commande par tension de la fréquence dudit oscillateur qui comprend un discriminateur de fréquence auquel est appliqué un premier signal de fréquence Fi ayant une relation de fréquence déterminée avec la fréquence Fp du signal de sortie dudit oscillateur, caractérisé en ce qu'il comprend en outre :
- un premier générateur d'un deuxième signal à une fréquence Fo ;
- un deuxième générateur d'un troisième signal à une fréquence F1 ;
- des moyens de commutation pour appliquer successivement au discriminateur de fréquence les deuxième et troisième signaux puis le premier signal;

- des moyens, connectés à la sortie du discriminateur de fréquence, pour fournir d'une part une première tension vo représentative de l'écart de fréquence Fo - F1 et, d'autre part, une deuxième tension v représentative de l'écart de fréquence Fi - Fo ;
- des moyens pour élaborer à partir de la première tension vo une tension de commande à appliquer audit oscillateur pour obtenir une fréquence déterminée Fp, et
- un circuit séquentiel pour élaborer des signaux de commande des moyens ci-dessus mentionnés.

D'autres caractéristiques et avantages de la présente invention apparaîtront à la lecture de la description suivante d'un exemple particulier de réalisation, ladite description étant faite en relation avec les dessins joints dans lesquels :
- la figure 1 est un schéma fonctionnel d'un dispositif d'asservissement en fréquence selon la présente invention,
- la figure 2 est un diagramme montrant la courbe de réponse tension/fréquence d'un discriminateur de fréquence, et
- la figure 3 est un diagramme montrant la courbe de réponse fréquence/tension d'un oscillateur à fréquence variable.

Un dispositif d'asservissement en fréquence d'un oscillateur 1 comprend, selon la présente invention, un discriminateur de fréquence 2 dont l'entrée est connectée par l'intermédiaire d'un commutateur 3, soit à la sortie de l'oscillateur 1, soit à la sortie d'un générateur 4 de signaux à des fréquences calibrées et stables Fo et F1. La connexion à l'oscillateur 1 s'effectue via un coupleur 5 disposé à la sortie de l'oscillateur et un circuit diviseur de fréquence 6. La connexion au générateur 4 s'effectue via un deuxième commutateur 7. Le rôle du circuit diviseur 6 est d'obtenir un signal dont la fréquence est dans la bande passante du discriminateur de fréquence 2.

La sortie du discriminateur de fréquence 2 est connectée à un circuit d'élaboration 8 de deux tensions d'écart apparaissant sur deux bornes de sortie qui sont connectées l'une directement à une première entrée d'un comparateur 9 est l'autre, à une deuxième entrée dudit comparateur 9 par l'intermédiaire d'un circuit de prépositionnement 10. La sortie du comparateur 9 est connectée à l'entrée de l'oscillateur 1 par l'intermédiaire d'un troisième commutateur 21 et d'un circuit de transposition de la tension de prépositionnement 11.

Les premier , deuxième et troisième commutateurs 3, 7 et 21, les circuits 8 et 11 reçoivent respectivement des signaux de commande d'un circuit séquentiel 12 par l'intermédiaire de conducteurs 29, 28, 31 ,32 ,33 ,30 et 34. Le début de séquence peut être commandé, soit par un signal extérieur Sext, soit par un signal fourni par un circuit à seuils 13 qui reçoit les signaux appliqués au comparateur 1.

L'oscillateur 1 est par exemple du type à fréquence variable commandé en tension, plus connu sous l'abréviation V.C.O., cette tension étant fournie par le circuit de transposition 11.

Le générateur 4 de signaux aux fréquences Fo et F1 peut être constitué par deux oscillateurs à quartz dont les fréquences sont stables dans le temps ou encore par un seul oscillateur à quartz à la fréquence Fo par exemple et d'un oscillateur à fréquence variable F1 commandé en tension (V.C.O.) dans une boucle d'asservissement dont la fréquence de référence est Fo.

Le discriminateur de fréquence 2 est de tout type connu mais il doit avoir une bonne linéarité . Il est par exemple réalisé sous une forme logique, ce qui implique que les signaux qui lui sont appliqués soient sous forme logique, c'est-à-dire sous forme de signaux carrés ou rectangulaires aux fréquences Fo, F1 et Fi. Le discriminateur de fréquence 2 fournit par exemple un signal dont la puissance moyenne varie linéairement avec la fréquence du signal qui lui est appliqué.

Le circuit d'élaboration 8 des tensions d'écart comprend deux circuits échantillonneurs- bloqueurs 14 et 15 et deux comparateurs 16 et 17. Chaque circuit échantilloneur-bloqueur 14 ou 15 est connecté à la sortie du discriminateur de fréquence 2 et échantillonne le signal qui lui est appliqué lorsqu'il reçoit un signal de commande Ech1 pour le circuit 14 et Ech0 pour le circuit 15, ces signaux étant fournis par le circuit séquentiel 12. Outre l'échantillonnage, ces circuits 14 et 15 réalisent une mémorisation du signal échantillonné. Le signal Vo mémorisé par le circuit 15, est appliqué aux deux comparateurs 16 et 17 alors que le signal V1 mémorisé par le circuit 14 est appliqué au seul comparateur 16 sur la deuxième entrée. Par ailleurs, le signal de sortie Vi du discriminateur de fréquence 2 est appliqué directement à la deuxième entrée du comparateur 17. Le comparateur 16 fournit un signal d'écart vo = Vo - V1 tandis que le comparateur 17 fournit un signal d'écart v = Vi - Vo.

Comme on l'exploiquera ci-après pour décrire le fonctionnement du dispositif, le signal V1 mesure la fréquence F1 tandis que le signal Vo mesure la fréquence Fo et il en résulte que leur différence vo mesure la différence de fréquence Fo - F1. Comme les fréquences Fo et F1 sont supposées fixes, la variation de vo ne peut provenir que du discriminateur de fréquence 2. En d'autres mots, la tension vo mesure la dérive du discriminateur. C'est cette tension qui est appliquée au circuit de prépositionnement 10 pour lui servir de référence et obtenir ainsi une tension de prépositionnement Vp qui varie en fonction des caractéristiques du discriminateur de fréquence 2.

Par ailleurs, la tension v = Vi - Vo mesure l'écart de fréquence de Fi- Fo et est appliquée au comparateur 9 où elle est comparée à la tension de prépositionnement Vp de manière à obtenir un signal logique 0 ou 1 selon que le signal v est supérieur ou inférieur à Vp.

Le circuit de prépositionnement 10 est de tout type connu et comprend, par exemple, un convertisseur numérique analogique 18 et une mémoire programmable 19 qui est adressée par des codes sur le groupe de conducteurs 20, chaque code définissant chacun une fréquence Fp à obtenir à la sortie de l'oscillateur 1. Le code d'adressage sélectionne dans la mémoire 19 un nombre qui définit sous une forme numérique, la tension Vp et qui commande le convertisseur numérique/analogique 18, cette tension Vp dépendant de l'écart vo = Vo - V1 qui sert de tension de référence au convertisseur 18.

Le circuit de transposition 11 de la tension de prépositionnement comprend un registre 22, un convertisseur numérique/analogique 23 connecté aux sorties du registre 22 et un circuit de décalage en tension connecté à la sortie du convertisseur 23. Ce registre 22 est prévu de manière à effectuer des approximations successives sous la commande des signaux qui lui sont appliqués, savoir un signal de départ fourni par le circuit séquentiel 12, des signaux d'horloge H fournis également par le circuit séquentiel 12 et des signaux logiques fournis par le comparateur 9.

Le circuit à seuils 13 comprend un amplificateur 24 de gain unité et deux comparateurs 25 et 26 qui reçoivent sur une première entrée le signal de sortie de l'amplificateur 24 et sur une deuxième entrée une tension de référence positive Sp pour le comparateur 25 et négative Sn pour le comparateur 26. Chaque comparateur 25 ou 26 fournit un signal logique $\overline{0}$ lorsque la tension v - Vp est comprise entre Sn et Sp et un signal logique $\underline{1}$ lorsque la tension v - Vp est supérieure en valeur absolue à Sn ou Sp.

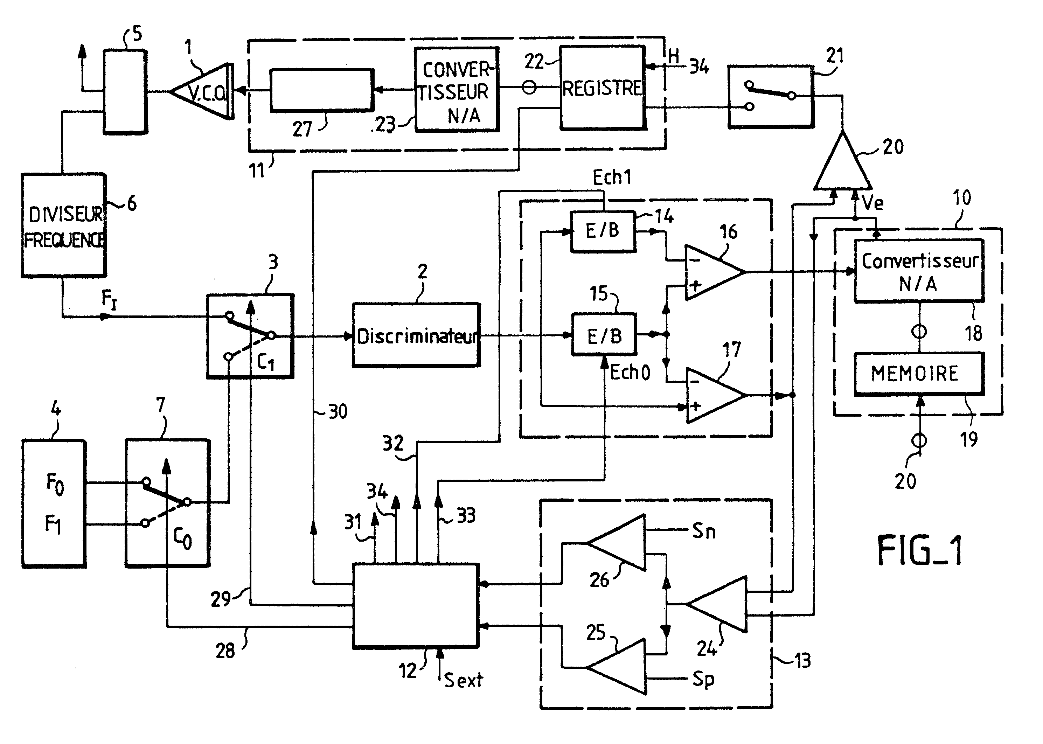

Le fonctionnement du dispositif d'asservissement en fréquence de l'oscillateur 1 est le suivant en supposant que l'on veuille obtenir une fréquence Fp à la sortie de l'oscillateur 1. A cette fréquence Fp correspond un code d'adressage Cp de la mémoire 19 sur le groupe de conducteurs 20 et une fréquence Fi à la sortie du circuit diviseur de fréquence 6. Le dispositif d'asservissement de la figure 1 permet de calculer par approximations successives la tension V qu'il faut appliquer à l'oscillateur 1 pour obtenir un signal de fréquence Fp à sa sortie.

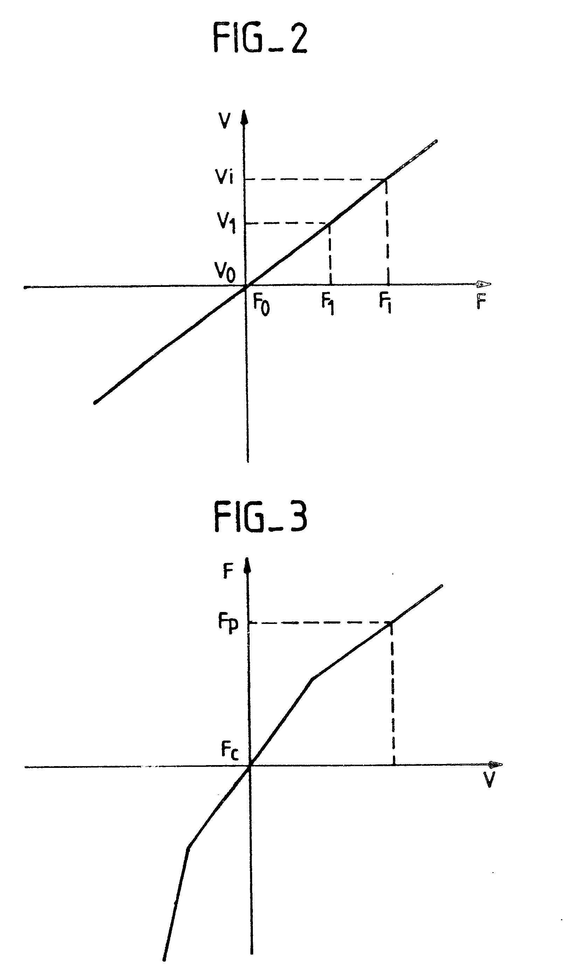

Ce code d'adressage Cp est concommittant avec un signal de démarrage Sext appliqué au circuit séquentiel 12. Ce circuit 12 fournit d'abord des signaux de commande des commutateurs 3, 7 et 21 pour les mettre respectivement dans les positions 1, 0 et 0. Il en résulte que la boucle d'asservissement est ouverte en deux endroits : à la sortie du circuit diviseur 6 et à la sortie du circuit du comparateur 9. Un signal de fréquence Fo est appliqué au discriminateur de fréquence 2 qui fournit alors une tension Vo proportionnelle à Fo. Cette tension est échantillonnée et mémorisée par l'échantillonneur bloqueur 15 lorsque le circuit séquentiel 12 fournit un signal Ech0 ; la tension échantillonnée a pour valeur Vo. Le circuit séquentiel 12 fournit ensuite un signal qui met le commutateur 7 dans la position 1 de sorte que le discriminateur 2 reçoit un signal à la fréquence F1 et fournit alors une tension V1 proportionnelle à F1. Un signal Ech1 élaboré par le circuit séquentiel 12 permet d'échantillonner et de mémoriser cette valeur V1 dans l'échantillonneur-bloqueur 14. Ces deux tensions Vo et V1 appliquées au comparateur 16, donnent une tension d'écart vo = Vo - V1 qui est proportionnelle à l'écart de fréquence Fo - F1. Ainsi, en cas de variation des caractéristiques du discriminateur 2, notamment la pente de la courbe 40 de la figure 2, on obtient une tension vo différente mais qui reste proportionnelle à la différence Fo-F1. Cette tension d'écart vo sert de tension de référence au convertisseur numérique/ anologique 18.

Le nombre lu dans la mémoire 19 à l'aide du code d'adressage Cp est représentatif de la fréquence Fp à obtenir, étant donné la courbe de la fréquence de l'oscillateur 1 en fonction de la tension de commande, mais en tenant compte de ce que représente en fréquence l'écart vo = Vo - V1. En d'autres mots, si l'on appelle F la variation élémentaire de fréquence, ou pas élémentaire à la sortie de l'oscillateur 1, il y correspond un pas de fréquence élémentaire f à la sortie du circuit diviseur 6. La différence Fo - F1 représente m pas élémentaires f, c'est-à-dire Fo - F1 = mf et m pas élémentaires F à la sortie de l'oscillateur 1 tel que Fs = Fc $^+$ mF. On comprend alors que si l'on désire obtenir une fréquence Fs = Fc + mF, il faille obtenir une tension Vm à la sortie du convertisseur 18 qui soit égale à vo, c'est-à-dire que le coefficient multiplicateur du convertisseur doit être égal à l'unité.

Comme le discriminateur 2 a une réponse linéaire, pour obtenir une fréquence Fs = Fc + pF, il faut enregistrer dans la mémoire 11 un coefficient multiplicateur p/m.

Après l'obtention de la tension de référence vo = Vo - V1, l'opération suivante consiste à fermer la boucle d'asservissement en agissant sur les commutateurs 3 et 21 pour les mettre respectivement en position 0 et 1 par l'intermédiaire des conducteurs 29 et 31 et en initialisant le registre 22 à une valeur moitié par l'intermédiaire du conducteur 30, ce qui correspond à la fréquence centrale Fc. Un signal à fréquence proche de Fo est ainsi appliqué au discriminateur 2 qui fournit un signal Vo de sorte qu'un signal v = Vi - Vo proche de zéro est appliqué à une entrée du comparateur 9, l'autre entrée recevant un signal Vp = p/mVe dans le cas où la fréquence à obtenir est Fs = Fc + pF. Comme v est inférieure à Vp, celà signifie que Fc est inférieure à Fs et qu'il faut donc augmenter la tension de commande de l'oscillateur 1 pour obtenir une augmentation de la fréquence, en supposant que la courbe de réponse de l'oscillateur en fonction de sa tension de commande est celle de la figure 3.

C'est ainsi que si le registre 22 comprend douze positions, sa valeur initiale sera le nombre binaire
0111 1111 1111 (1)
Si v est inférieure à Vp, au signal d'horloge H sur le conducteur 34, le nombre binaire affiché par le registre 22 devient :
1011 1111 1111 (2),
c'est-à-dire que l'on augmente le nombre (1) d'un poids égal à la moitié du chiffre le plus significatif. Par contre si v avait été supérieure à Vp, le chiffre binaire affiché par le registre 22 serait devenu :
0011 1111 1111 (3),
c'est-à-dire que l'ont aurait diminué le nombre (1) d'un poids égal à la moitié du chiffre le plus significatif.

Le nombre binaire (2), par l'effet du convertisseur 23 et du circuit de décalage de tension 27, augmente la tension de commande de l'oscillateur 1 et la fréquence de ce dernier augmente, ce qui donne une nouvelle valeur de Fs et Fi et donc de v. Si cette nouvelle valeur de v est inférieure à Vp, au signal d'horloge H, le nombre binaire affiché par le registre 22 devient :
1101 1111 1111 (4)
c'est-à-dire que l'on augmente le nombre (2) d'un poids égal au quart du chiffre le plus significatif. Dans le cas contraire, on diminue d'un poids égal au quart du chiffre le plus significatif pour obtenir :
0001 1111 1111 (5)

Ces incrémentations en plus ou en moins du registre 22 s'effectuent en fonction des résultats des comparaisons successives dans le comparateur 9 et au rythme des signaux d'horloge H jusqu'à l'obtention du chiffre le moins significatif, c'est-à-dire après douze impulsions d'horloge H si ce nombre binaire a douze chiffres. A la fin de ce cycle de comparaisons et d'approximations successives, la tension v = Vo - Vi est sensiblement égale à la tension vp avec une erreur égale au plus àu poids du chiffre le moins significatif. on a alors Fs = Fc + pF et on ouvre alors la boucle d'asservissement en fréquence en ouvrant l'interrupteur 21 par un signal sur le conducteur 31.

Un tel prépositionnement de la fréquence de l'oscillateur 1 est obtenu très rapidement, en quelques microsecondes, par exemple une douzaine de microsecondes dans le cas où les signaux d'horloge ont une fréquence d'un mégahertz et pour un registre à douze positions.

Il est clair que ce cycle de prépositionnement doit être effectué chaque fois qu'il y a un changement de la fréquence, mais il peut être prévu de la faire systématiquement à des instants entre deux changements en déclenchant le circuit séquentiel 12 à intervalles réguliers. On peut ainsi répéter un tel cycle pour une fréquence Fs donnée chaque fois que l'on détecte une modification significative de la fréquence Fs. Un tel contrôle peut être obtenu à l'aide du circuit à seuils 13 qui reçoit les tensions v et Vp et qui compare leur différence à des seuils Sn et Sp de manière à déclencher le circuit séquentiel 12 dès que l'on détecte une variation de la fréquence Fs qui résulte en une variation de v - Vp supérieure aux seuils Sn et Sp. De cette manière, on obtient un asservissement en fréquence de l'oscillateur 1, ce qui permet de tenir compte de dérives des caractéristiques des différents composants, notamment de celles du discriminateur de fréquence 2 et de l'oscillateur 1.

Le dispositif d'asservissement en fréquence qui vient d'être decrit permet donc de s'affranchir des modifications des caractéristiques du discriminateur de fréquence 2 en premier lieu mais aussi de celles d'autres éléments du dispositif comme les convertisseurs numériques analogiques 18 et 23, le circuit de décalage en tension 27 ou encore les échantillonneurs-bloqueurs 14 et 15 et les comparateurs 16 et 17.

Le dispositif d'asservissement selon l'invention peut être utilisé dans un système d'asservissement en phase pour amener la fréquence du signal dans la zone d'accrochage de la boucle d'asservissement en phase.

**Revendications**

1 - Dispositif d'asservissement en fréquence d'un oscillateur (1) de type à commande par tension de la fréquence dudit oscillateur qui comprend un discriminateur de fréquence (2) auquel est appliqué un premier signal de fréquence Fi ayant une relation de fréquence déterminée avec la fréquence Fp du signal de sortie dudit oscillateur (1), caractérisé en ce qu'il comprend en outre :
- un premier générateur (4) d'un deuxième signal à une fréquence Fo ;
- un deuxième générateur (4) d'un troisième signal à une fréquence F1 ;
- des moyens de commutation (3, 7) pour appliquer successivement au discriminateur de fréquence (2) les deuxièmes et troisièmes signaux puis le premier signal ;
- des moyens (8) pour fournir, d'une part une première tension vo représentative de l'écart de fréquence Fo - F1 et, d'autre part, une deuxième tension v représentative de l'écart de fréquence Fi - Fo ;
- des moyens (10, 9, 11) pour élaborer à partir de la première tension vo une tension de commande à appliquer audit oscillateur (1) pour obtenir une fréquence déterminée Fp, et,
- un circuit séquentiel (12) pour élaborer des signaux de commande des moyens ci-dessus mentionnés.

2 - Dispositif d'asservissement en fréquence selon la revendication 1, caractérisé en ce que les moyens pour élaborer, à partir de la première tension vo, une tension de commande de la fréquence de l'oscillateur (1) comprennent :
- un circuit de prépositionnement (10) qui, recevant d'une part un code représentatif Cp de la fréquence Fp à obtenir, et d'autre part la tension vo, fournit une tension représentative vp, de ladite tension de commande qui dépend de la pente de la courbe tension en fonction de la fréquence dudit discriminateur de fréquence (2),
- un comparateur (9) qui compare ladite tension représentative vp à la tension v et fournit un signal logique selon le résultat de la comparaison,
- un circuit d'élaboration (11) de la tension de commande Vp de l'oscillateur (1) qui détermine cette tension par approximations successives selon le signal logique fourni par le comparateur (9).

3 - Dispositif d'asservissement en fréquence selon la revendication 2, caractérisé en ce qu'il comprend en outre un circuit à seuils (13) qui fournit une tension d'écart représentative de la différence des tensions v - Vp, cette tension d'écart étant comparée à des seuils prédéterminés de manière à fournir un signal de déclenchement du circuit séquentiel (12) dès que la tension d'écart dépasse lesdits seuils prédéterminés.

4 - Dispositif d'asservissement en fréquence selon la revendication 1 ou 2, caractérisé en ce qu'il comprend des moyens (35) pour déclencher le circuit séquentiel à des intervalles de temps déterminés.

5 - Dispositif d'asservissement en fréquence selon l'une quelconque des revendications 2 à 4, caractérisé en ce que le circuit de prépositionnement (10) comprend un convertisseur numérique analogique (18) et une mémoire (19) qui, adressée par un code Cp, fournit un nombre binaire de commande dudit convertisseur de manière à obtenir la tension Vp à partir de la tension de référence vo.

6 - Dispositif d'asservissement en fréquence selon l'une quelconque des revendications 2 à 5, caractérisé en ce que le circuit d'élaboration (11) de la tension de commande Vp comprend un convertisseur numérique analogique (23), un registre à approximations successives (22) et un circuit de transposition (27) de la tension de sortie du convertisseur 23, ledit registre (22) étant commandé par le signal logique de sortie du comparateur (9) de manière qu'un ou deux circuits bistables changent d'état selon la valeur dudit signal logique du comparateur (9)

7 - Dispositif d'asservissement en fréquence selon l'une quelconque des revendications 1 à 6, caractérisé en ce que les moyens (8) comprennent deux circuits échantillonneurs-bloqueurs (14, 15) qui fournissent l'un (15) un signal Vo proportionnel à la fréquence Fo et l'autre (14) un signal V1 proportionnel à la fréquence F1 et deux comparateurs (16, 17) qui fournissent l'un (16) la tension vo = Vo - V1 et l'autre (17) la tension v = Vi - Vo.

8 - Dispositif d'asservissement en fréquence selon l'une quelconque des revendications 1 à 7, caractérisé en ce que les premier et second générateurs sont constitués chacun d'un oscillateur à quartz.

9. Dispositif d'asservissement en fréquence selon l'une quelconque des revendications 1 à 7, caractérisé en ce que les premier et second générateurs sont constitués à l'aide d'un seul oscillateur à quartz.

FIG_1

EP 0 326 466 A1

# FIG_2

# FIG_3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-1 324 563 (INTERNATIONAL STANDARD ELECTRIC) <br> * En entier * <br> --- | 1 | H 03 L 7/02 |
| A | FR-A-2 192 412 (LOEWE OPTA) <br> * Page 2, ligne 18 - page 9, ligne 14; figure * <br> --- | 1 | |
| A | EP-A-0 041 882 (THOMSON-CSF) <br> * Page 8, ligne 7 - page 11, ligne 31; figures 4,5 * <br> --- | | |
| A | FR-A-2 439 511 (LICENTIA) <br> ----- | | |

DOMAINES TECHNIQUES
RECHERCHES (Int. Cl.4)

H 03 L
H 03 C

Le présent rapport a été établi pour toutes les revendications

| Lieu de la recherche | Date d'achèvement de la recherche | Examinateur |
|---|---|---|
| LA HAYE | 28-04-1989 | DHONDT I.E.E. |